Europäisches
Patentamt

European
Patent Office

Office européen
des brevets

(11) **EP 2 960 922 B1**

(12) **EUROPEAN PATENT SPECIFICATION**

(45) Date of publication and mention
of the grant of the patent:
**14.06.2017 Bulletin 2017/24**

(51) Int Cl.:
***H01H 47/00*** (2006.01)          ***H01H 9/16*** (2006.01)
***B61L 3/12*** (2006.01)

(21) Application number: **14305992.1**

(22) Date of filing: **24.06.2014**

(54) **Device and method for determining a state of an electromechanical relay contact, and a system including such a device**

Vorrichtung und Verfahren zur Bestimmung des Betriebszustandes eines elektromechanischen Relaiskontakts und System mit solch einer Vorrichtung

Dispositif et procédé pour déterminer un état d'un contact de relais électromécanique et système comprenant un tel dispositif

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**30.12.2015 Bulletin 2015/53**

(73) Proprietor: **ALSTOM Transport Technologies**
**93400 Saint-Ouen (FR)**

(72) Inventor: **Lemoine, Jocelyn**
**69003 Lyon (FR)**

(74) Representative: **Lavoix**
**2, place d'Estienne d'Orves**
**75441 Paris Cedex 09 (FR)**

(56) References cited:
**DE-A1- 4 221 916          JP-A- 2002 037 071**
**US-A1- 2004 174 074      US-A1- 2004 189 319**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a state determination device for determining a state of an electromechanical relay contact among a closed state and an open state. The relay contact is movable between the closed state and the open state, the relay contact being connected to a resonant circuit, and the resonant circuit has a resonance frequency and includes at least a component among a capacitor and a coil.

The invention also relates to a system comprising the resonant circuit, the electromechanical relay contact connected to the resonant circuit and such a state determination device.

The invention also relates to a method for determining the state of the electromechanical relay contact among the closed state and the open state.

The invention concerns the field of electromechanical relays, in particular for railways applications, such a state determination device being for example adapted to be used to read signal box relays contacts, said contacts being connected to beacons.

EP 2 104 010 B1 relates to a detection device for detecting, with a safety threshold, state information from an analog signal, in particular for a railway system. The detection device includes a decision element and at least two diversification acquisition chains. Each acquisition chain includes, in series, a circuit for adapting an analog signal into an adapted continuous analog safety signal, and a non-safety chain threshold circuit which is capable of supplying chain state information including a voltage source.

The threshold circuit of each chain includes an electronic analog-digital conversion circuit, which is capable of receiving the adapted continuous analog safety signal and the input signal of the converter, and of supplying a digital output signal sampling the input signal of the converter at a predetermined sampling frequency. The threshold circuit includes a unit for comparing the digital output signal to a reference digital signal, said unit being capable of supplying a chain output item of state information as the result of the comparison.

The detection device further includes a circuit for detecting a fault in the device, said circuit being capable of comparing mutually the digital output signals supplied at inputs and derived respectively from the analog-digital conversion circuits, and of supplying at an output a consistency result which is a function of the mutual comparison of the digital output signals.

Such a detection device includes a safety input cell designed with no electromechanical relay but only with electronic components (Zener diode, opto-coupler, diode and resistor) to detect an AC input voltage.

However such a device is not able to read a contact state connected to a complex impedance load, such as a resonant circuit including at least a component among a capacitor and a coil.

Moreover, DE 42 21 916 A1 discloses a system according to the preamble of claim 1 and a method according to the preamble of claim 11. A goal of the present invention is to propose a state determination device for determining a state of an electromechanical relay contact among a closed state and an open state when the relay contact is connected to a complex impedance load, such as a resonant circuit including at least a component among a capacitor and a coil.

To this end, the invention relates to a system according to claim 1.

Thanks to the invention, an alternative voltage signal is injected into the resonant circuit, the alternative voltage signal having a frequency which is comprised between 0.9 times the resonance frequency and 1.1 times the resonance frequency. At a frequency substantially equal to its resonance frequency, the resonant circuit operates as a resistive impedance, said impedance being maximal, so that the measured electric magnitude is stable and has a maximal amplitude. The state determination device therefore allows better determining the state of the electromechanical relay contact among the closed state and the open state.

In other words, the best way to perform a distinction between a contact open or closed which is connected to the resonant circuit is to evaluate the impedance value of this circuit around its resonance frequency.

According to other advantageous aspects of the invention, the state determination device comprises one or more of the following features taken alone or according to all technically possible combinations:

- the generation unit includes a multiplexer for selecting one signal among the delivered signals, the selected signal being the generated alternative voltage signal;
- the generation unit has an output impedance greater than 150 kΩ, preferably comprised between 180 kΩ and 200 kΩ;
- the measuring unit includes at least one filter for attenuating the harmonics of the generated frequency in the measured electric magnitude;
- the measuring unit includes several filters, one for each frequency generated by the generator;
- the determination unit includes a pulse-width modulator for creating a PWM signal according to the measured electric magnitude, and wherein the state of the electromechanical relay contact is determined according to the created PWM signal;
- the created PWM signal has a duty cycle value, the duty cycle value being greater for the closed state than for the open state;

- the determination unit includes a comparator for comparing the measured electric magnitude with a predetermined threshold;
- the electric magnitude is a voltage.

According to another advantageous aspect of the invention, the system comprises the following feature:

- the generation unit and the measuring unit are both connected at a connection point between the resonant circuit and the relay contact.

The invention also relates to a method according to claim 11.

The invention will be better understood upon reading of the following description, which is given solely by way of example and with reference to the appended drawings, in which:

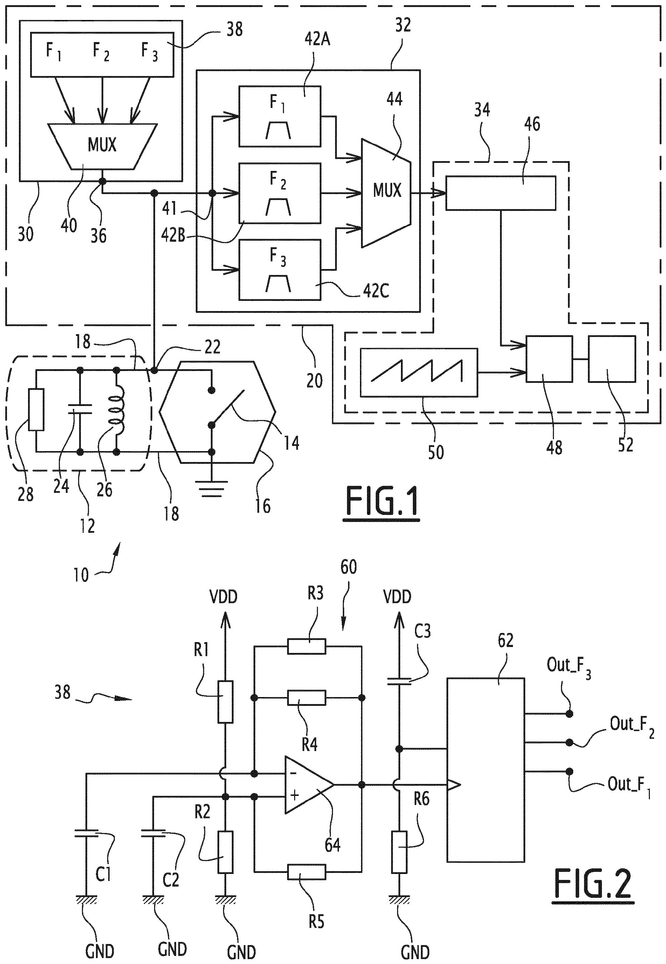

- Figure 1 is a schematic view of an electric system comprising a resonant circuit, an electromechanical relay contact connected to the resonant circuit, and a state determination device, according to the invention, for determining the state of the relay contact; said determination device including a generation unit for generating an alternative voltage signal and for injecting the generated alternative voltage signal into the resonant circuit, a measuring unit for measuring an electric magnitude relative to the impedance of the resonant circuit after injection of the generated alternative voltage signal, and a determination unit for determining the state of the electromechanical relay contact according to the measured electric magnitude;
- Figure 2 is a circuit diagram of a first generator included in the generation unit of Figure 1, said first generator being adapted for delivering several alternative voltage signals with distinct frequencies;
- Figure 3 is a circuit diagram of filters included in the measuring unit of Figure 1, said filters being configured for attenuating the harmonics of the generated frequency in the measured electric magnitude;
- Figure 4 is a circuit diagram of a conversion stage included in the determination unit of Figure 1, said conversion stage being adapted for converting into a direct signal an alternative signal delivered at the output of the filters of Figure 3;
- Figure 5 is a circuit diagram of a pulse-width modulator included in the determination unit of Figure 1, said pulse-width modulator being adapted for creating a PWM signal according to the measured electric magnitude and to a reference signal, in particular according to the direct signal delivered at the output of the conversion stage of Figure 4;
- Figure 6 is a circuit diagram of a second generator included in the determination unit of Figure 1, said second generator being adapted for generating the reference signal used by the pulse-width modulator of Figure 5, said reference signal being in particular a saw-toothed signal ; and
- Figure 7 is a flowchart of a method, according to the invention, for determining the state of the electromechanical relay contact among the closed state and the open state.

In the following, the expression "substantially equal to" defines an equality relation to more or less 10%.

In Figure 1, an electric system 10 comprises a resonant circuit 12, a contact 14 of an electromechanical relay 16, the contact 14 being connected to the resonant circuit 12 via electric cables 18. The electric system 10 also comprises a state determination device 20 for determining a state of the relay contact 14 among a closed state and an open state, said determination device 20 being connected at a connection point 22 between the resonant circuit 12 and the relay contact 14.

The electric system 10 is for example used in railways applications, the resonant circuit 12 being for example a passive beacon and the relay contact 14 being associated with a signal box, such as a light signal box.

The resonant circuit 12 has a resonance frequency $F_0$ and includes at least a component among a capacitor 24 and a coil 26. In the example of Figure 1, the resonant circuit includes both the capacitor 24 and the coil 26, and also a resistor 28, each one of the capacitor 24, the coil 26 and the resistor 28 being connected in parallel with the relay contact 24.

The resonant circuit 12 has an impedance Z, and the norm of said impedance Z is maximal at the resonance frequency $F_0$ of the resonant circuit 12. Around this resonance frequency $F_0$, the circuit impedance Z is equivalent to a total equivalent resistance Rt. In the example of Figure 1, around this resonance frequency $F_0$, the energy absorbed by the capacitor 24 is therefore equal to the energy transmitted by the coil 26 and vice-versa.

At resonance frequency $F_0$, the circuit impedance Z is equal to the total equivalent resistance Rt:

$$Z = R_t \qquad\qquad\qquad (1)$$

The contact 14 and the electromechanical relay 16 are known *per se.*

The contact 14, also called interrupter, is movable between the closed state and the open state. As known *per se*, the closed state allows the current to flow through the contact 14 and the open state corresponds to an opened electric link and to an absence of current flow through the contact 14.

The electric cables 18 have, for example, a length from a few meters to a few hundreds of meters.

The state determination device 20 includes a generation unit 30 for generating an alternative voltage signal and for injecting the generated alternative voltage signal into the resonant circuit 12, a measuring unit 32 for measuring an electric magnitude relative to the impedance of the resonant circuit 12 after injection of the generated alternative voltage signal, and a determination unit 34 for determining the state of the electromechanical relay contact 14 according to the measured electric magnitude.

The connection point 22 is for example a terminal connected, via the cables 18, on one hand to the resonant circuit 12 and on the other hand to the relay contact 14.

The generation unit 30 and the measuring unit 32 are both connected at the connection point 22 between the resonant circuit 12 and the relay contact 14.

The generation unit 30 has an output terminal 36 and is adapted for delivering at its output terminal 36 the generated alternative voltage signal. The output terminal 36 is connected to the connection point 22, which is itself connected between the resonant circuit 12 and the relay contact 14. The generated alternative voltage signal delivered by the generation unit 30 is therefore injected into the resonant circuit 12.

The generated alternative voltage signal has a frequency $F_G$, also called generated frequency, which is comprised between 0.9 times the resonance frequency $F_0$ and 1.1 times the resonance frequency $F_0$. The generated frequency $F_G$ therefore verifies the following inequality:

$$0,9 \times F_0 \leq F_G \leq 1,1 \times F_0 \qquad\qquad (2)$$

In the example of Figures 1 to 6, and in particular of Figures 2 to 6, the state determination device 20 that will be described hereinafter includes analog circuits.

Alternatively, and as described later in more detail, it will be apparent for the skilled person in the art that the state determination device 20 includes digital circuits.

The generation unit 30 includes, as shown in Figure 1, a first generator 38 for delivering several alternative voltage signals with distinct frequencies and a first multiplexer 40 for selecting one signal among the signals delivered by the first generator 38, the selected signal being the generated alternative voltage signal.

In the described embodiment, the first generator 38 is configured for delivering three distinct alternative voltage signals: a first signal with a first frequency $F_1$, a second signal with a second frequency $F_2$, and a third signal with a third frequency $F_3$. The first frequency $F_1$, the second frequency $F_2$ and respectively the third frequency $F_3$ are, for example, substantially equal to 500 Hz, 1 kHz and respectively 2 kHz.

The generation unit 30 has an output impedance $Z_{Out}$ which is, for example, greater than 150 kΩ, preferably comprised between 180 kΩ and 200 kΩ. Alternatively, the output impedance $Z_{Out}$ has a much lower value and is for example substantially equal to 10 kΩ.

The measuring unit 32 has an input terminal 41 and is adapted for measuring the electric magnitude relative to the impedance Z of the resonant circuit 12 after injection of the generated alternative voltage signal. The input terminal 41 is connected to the connection point 22, which is itself connected between the resonant circuit 12 and the relay contact 14. The electric magnitude measured by the measuring unit 32, after injection of the generated voltage signal, is therefore relative to the impedance Z of the resonant circuit 12 after said injection when the relay contact 14 is open.

The electric magnitude is for example the voltage $V_{meas}$ at the connection point 22.

The measuring unit 32 includes at least one filter 42 for attenuating the harmonics of the generated frequency $F_G$ in the measured electric magnitude $V_{meas}$. In the example of Figure 1, the measuring unit 32 includes a first filter 42A for attenuating the harmonics of the first frequency $F_1$, a second filter 42B for attenuating the harmonics of the second frequency $F_2$, and a third filter 42C for attenuating the harmonics of the third frequency $F_3$.

In the example of Figure 1, the measuring unit 32 also includes a second multiplexer 44 connected at the output of the three filters 42A, 42B, 42C and adapted for selecting one filtered signal among the filtered signals which are issued from the filters 42A, 42B, 42C.

The determination unit 34 is adapted for determining the state of the relay contact 14 according to the electric magnitude $V_{meas}$ measured by the measuring unit 32.

In the example of Figure 1, the determination unit 34 includes a conversion stage 46 for converting an AC signal into a DC signal, the conversion stage 46 being connected at the output of the determination unit 32. The conversion stage 46 is therefore adapted to convert the measured electric magnitude, which is an alternative magnitude, into a direct magnitude.

In the example of Figure 1, the determination unit 34 also includes a pulse-width modulator 48 for creating a PWM signal according to the measured electric magnitude and to a reference signal, said reference signal being in particular a saw-toothed signal, and a second generator 50 for generating a part of the reference signal used by the pulse-width modulator 48.

In the example of Figure 1, the determination unit 34 also includes a determination stage 52, the determination stage 52 being connected at the output of the pulse-width modulator 48 and adapted to determine the state of the relay contact 14 according to the created PWM signal. In particular, the determination stage 52 is configured to determine the state of the relay contact 14 according to a duty cycle value of the created PWM signal, said duty cycle value being greater for the closed state of the relay contact 14 than for the open state of said contact 14.

In an alternative embodiment, not shown, the determination unit 34 includes a comparator for comparing, with a predetermined threshold, the measured electric magnitude which issued by the measuring unit 32.

A detailed embodiment of the generation unit 30, of the measuring unit 32 and of the determination unit 34 will now be described in view of circuit diagrams of Figures 2 to 6, which are given solely by way of example.

In Figure 2, the first generator 38 includes an oscillator 60 and a counter 62 connected at the output of the oscillator 60. The oscillator 60 is adapted for delivering a clock signal with a predefined clock frequency and the counter 62 is adapted to count one or several edges of the clock signal in order to deliver the first signal with the first frequency $F_1$ at an output $Out\_F_1$, the second signal with the second frequency $F_2$ at an output $Out\_F_2$, and the third signal with the third frequency $F_3$ at an output $Out\_F_3$. The oscillator 60 comprises a first operational amplifier 64 and first and second capacitors C1, C2 for setting the value of the predefined clock frequency. The predefined clock frequency is for example substantially equal to 2 kHz. The first capacitor C1, respectively the second capacitor C2, is for example connected to the inverting input, respectively the non-inverting input, of the first operational amplifier 64. In addition, the oscillator 60 comprises two resistors R1, R2 connected between a high-level reference potential VDD, respectively a low-level reference potential GND, and the non-inverting input of the first operational amplifier 64. In addition, the oscillator 60 comprises two resistors R3, R4 connected in parallel between the output and the inverting input of the first operational amplifier 64, and a resistor R5 connected between the output and the non-inverting input of said first operational amplifier 64. The output of the first operational amplifier 64 is connected to a clock input of the counter 62 and the first generator 38 includes a capacitor C3 and a resistor R6 connected between the high-level potential VDD, respectively the low-level potential GND, and another input of the counter 62.

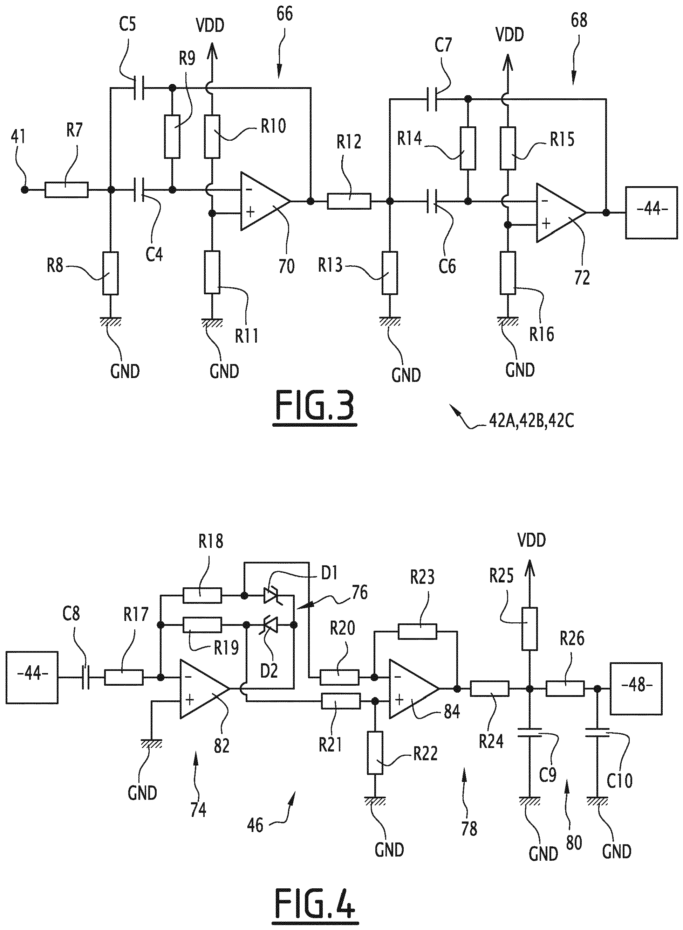

In Figure 3, each filter 42A, 42B, 42C includes a first filtering stage 66 and a second filtering stage 68 connected in series between the input terminal 41 and the second multiplexer 44, the filters 42A, 42B, 42C being connected to different inputs of the second multiplexer 44. For each filter 42A, 42B, 42C, the combination of the first filtering stage 66 and the second filtering stage 68 is equivalent to a band-pass filter with a respective predefined cut-off frequency $Fco_A$, $Fco_B$, $Fco_C$, i.e. a first cut-off frequency $Fco_A$ for the first filter 42A, a second cut-off frequency $Fco_B$ for the second filter 42B, a third cut-off frequency $Fco_C$ for the third filter 42C. The band-pass filter is adapted to attenuate frequencies which are not in an interval around the predefined cut-off frequency $Fco_A$, $Fco_B$, $Fco_C$.

The first filter 42A is related to the first frequency $F_1$ and the first cut-off frequency $Fco_A$ is substantially equal to the first frequency $F_1$. Similarly, the second cut-off frequency $Fco_B$ is substantially equal to the second frequency $F_2$ and the third cut-off frequency $Fco_C$ is substantially equal to the third frequency $F_3$. One filter among the three filters 42A, 42B, 42C is therefore adapted to attenuate the harmonics of the generated frequency $F_G$ in the measured electric magnitude, depending of the frequency selected among the three frequencies $F_1$, $F_2$, $F_3$ for obtaining the generated frequency $F_G$. The first filtering stage 66, and respectively the second filtering stage 68, comprises a second operational amplifier 70, and respectively a third operational amplifier 72, and also capacitors C4, C5, C6, C7 for setting the value of the corresponding cut-off frequency $Fco_A$, $Fco_B$, $Fco_C$. The first filtering stage 66 also comprises resistors R7, R8, R9, R10, R11 and the second filtering stage 68 comprises resistors R12, R13, R14, R15, R16.

In figure 4, the conversion stage 46 includes a first amplifying stage 74, a bridge rectifier 76, a second amplifying stage 78 and a third filtering stage 80 connected in series between the second multiplexer 44 and the pulse-width modulator 48. The first amplifying stage 74 comprises a fourth operational amplifier 82, resistors R17, R18, R19 and a capacitor C8. The bridge rectifier 76 comprises diodes D1 and D2 and is for example a full wave bridge rectifier without threshold. The second amplifying stage 78 comprises a fifth operational amplifier 84 and resistors R20, R21, R22, R23. The third filtering stage 80 includes capacitors C9, C10 for filtering residual AC components and resistors R24, R25, R26.

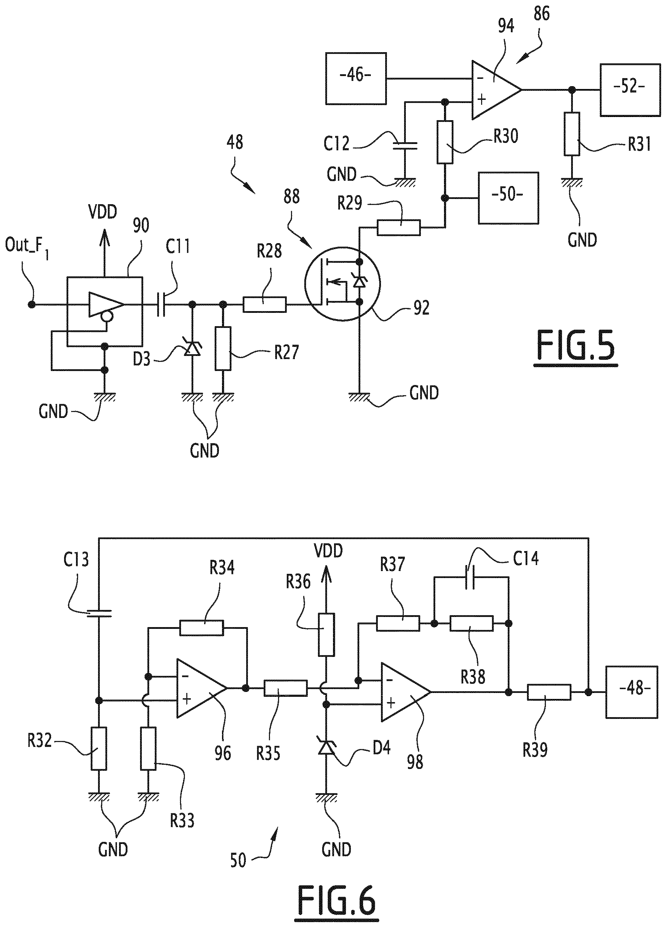

In figure 5, the pulse-width modulator 48 includes a comparator 86 and a reference stage 88. The comparator 86 is configured to compare the filtered measured signal issued from the conversion stage 46 with the reference signal issued from the reference stage 88, said reference signal being in particular a saw-toothed signal. The comparator 86 is therefore adapted to deliver the PWM signal to the determination stage 52, said PWM signal being based on the measured electric magnitude and the reference signal. The reference stage 88 is configured to deliver the reference signal, for example the saw-toothed signal. The reference stage 88 includes a buffer 90 and a transistor 92 for cutting the signal delivered by the second generator 50 which is for example in form of a ramp. The input of the buffer 90 is connected to the terminal Out_$F_1$ and receives the first signal with the first frequency $F_1$ and the output of the buffer 90 is connected via a capacitor C11, a diode D3, resistors R27, R28 to the gate of the transistor 92. The transistor 92 is for example a MOSFET (Metal-Oxide-Semiconductor Field-Effect Transistor) with the source connected to the low-level reference potential GND and the drain connected via a resistor R29 to the output of the second generator 50. The comparator 86 comprises a sixth operational amplifier 94 with the inverting terminal connected to the conversion stage 46 and the non-inverting terminal connected both to the low-level reference potential GND via a capacitor C12 and to the connection of the resistor R29 and the output of the second generator 50 via a resistor R30. The output of the sixth operational amplifier 94 is connected to the determination stage 52, said output being also connected to the low-level reference potential GND via a resistor R31.

In figure 6, the second generator 50 comprises a seventh operational amplifier 96 and a eighth operational amplifier 98 connected in series and also capacitors C13, C14, resistors R32, R33, R34, R35, R36, R37, R38, R39 and a diode D4. The second generator is configured for delivering a signal in form of a ramp. The diode D4 is connected between the low-level reference potential GND and the non-inverting input of the eighth operational amplifier 98.

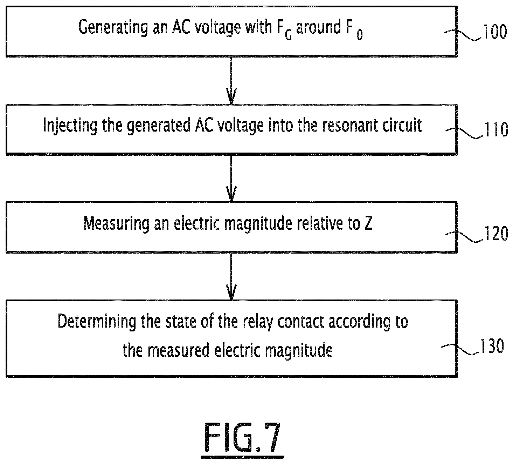

The operation of the system 10 according to the invention will now be described in view of Figure 7 illustrating a flowchart of a method, according to the invention, for determining the state of the relay contact 14 among the closed state and the open state.

In an initial step 100, the generation unit 30 generates the alternative voltage configured to be injected into the resonant circuit 12. According to the invention, the generated frequency $F_G$ of the generated alternative voltage signal has a value around the resonance frequency $F_0$ of the resonant circuit 12, the generated frequency $F_G$ being preferably comprised between 0.9 times the resonance frequency $F_0$ and 1.1 times the resonance frequency $F_0$.

In the following step 110, the generation unit 30 injects into the resonant circuit 12 the generated alternative voltage signal with its frequency $F_G$ close to the resonance frequency $F_0$ of the resonant circuit 12. At this particular frequency $F_G$, the impedance Z of the resonant circuit 12 is high and quite purely resistive. Therefore the resonant circuit 12 doesn't disturb the acquisition of the contact state.

The frequency $F_G$ of the signal injected into the resonant circuit 12 is preferably comprised between 0.9 x $F_0$ and 1.x $F_0$ as the impedance Z is maximal at the resonance frequency $F_0$.

In the following step 120, the measuring unit 32 measures the electric magnitude relative to the impedance Z of the resonant circuit 12 after injection of the generated alternative voltage signal. This signal is read back through the corresponding filter 42A, 42B, 42B which is adapted to check if it corresponds to the injected frequency by removing the harmonics of frequency $F_G$ in the measured electric magnitude. The electric magnitude is for example the voltage $V_{meas}$ at the connection point 22.

In the final step 130, the determination unit 34 determines the state of the electromechanical relay contact 14 among the closed state and the open state, according to the measured electric magnitude.

In the example of Figure 4, the signal issued from the filters 42A, 42B, 42B and the multiplexer 44, goes through the bridge rectifier 76 without threshold, in order to bring back to zero the minimal value of said signal, said signal being sinusoidal with a frequency close to the resonance frequency $F_0$. The signal is finally filtered through the third filtering stage 80 with smoothing capacitors C9, C10 to obtain a DC voltage which is reflecting the impedance Z of the resonant circuit 12. A high value of said DC voltage corresponds to a high value of the impedance Z and a low value of said DC voltage corresponds to a low value of the impedance Z.

In order to convert this signal in digital format by using analog components only (for low consumption purpose), a PWM modulation is performed via the pulse-width modulator 48. The duty cycle value of the created PWM signal then corresponds directly to the value of the impedance Z. In the described embodiment, a high duty cycle value corresponds to a low value of the impedance Z and a low duty cycle value corresponds to a high value of the impedance Z.

Finally, in the described embodiment, a high duty cycle value shows that the relay contact 14 is closed and a low duty cycle value shows that the relay contact 14 is open. In other words, the duty cycle value is greater for the closed state than for the open state.

Thus, the state determination device 20 and the method according to the invention allow a better detection of the contact state and ensure a safe, reliable and non-intrusive reading of the relay contact state.

In addition, safe reading is ensured by periodic self-tests of injected and detected signals.

Furthermore, the state determination device 20 is non-intrusive when it is connected in parallel with the resonant circuit 12, as described in the example of Figure 1.

Further, when the output impedance $Z_{Out}$ of the generation unit 30 is greater than 150 k$\Omega$, preferably comprised between 180 k$\Omega$ and 200 k$\Omega$, the resonant circuit 12 is not energized, because the resulting voltage amplitude due to the state determination device 20 is lower than 100mV.

In addition, the state determination device 20 is configured for being adapted to several different resonant circuits, when the first generator 38 is configured for delivering several alternative voltage signals, for example the first, second and third signals with the respective first, second and third frequencies $F_1$, $F_2$, $F_3$. Several signals are injected sequentially at different frequencies close to the resonance frequency of each resonant circuit and each resonant circuit is then activated by its own resonance frequency.

According to another embodiment, the state determination device 20 includes digital circuits.

The generation unit 30 is a digital generation unit for generating the alternative voltage signal and for injecting the generated alternative voltage signal into the resonant circuit 12. The generation unit 30 is preferably configured for successively varying the frequency of the generated alternative voltage signal in order to dynamically evaluate the resonance frequency $F_0$.

The measuring unit 32 is a digital measuring unit for measuring the electric magnitude relative to the impedance of the resonant circuit 12 after injection of the generated alternative voltage signal, for example for measuring the voltage $V_{meas}$ at the connection point 22.

The determination unit 34 is a digital determination unit for determining the state of the electromechanical relay contact 14 according to the measured electric magnitude.

According to this embodiment, the determination method includes two successive phases: a calibration phase and a nominal phase.

During the calibration phase which is an initial phase, the alternative voltage signal (to be injected in the nominal phase) is determined by scanning, via the generation unit 30, a range of frequencies in order to dynamically and accurately estimate the resonance frequency $F_0$.

During the nominal phase, the generated alternative voltage signal is injected into the resonant circuit 12 with a frequency corresponding to the resonance frequency $F_0$ which was estimated during the calibration phase. After said injection, the electric magnitude is measured, and optionally digitally filtered, by the measuring unit 32, so that the determination unit 34 is able to determine the state of the relay contact 14.

The state determination device 20 and the method according to the invention are therefore suitable for determining the state of the relay contact 14 when said contact is connected to a complex impedance load, such as the resonant circuit 12 including at least a component among the capacitor 24 and the coil 26.

**Claims**

1. A system (10) comprising:

   - a resonant circuit (12), the resonant circuit (12) having a resonance frequency ($F_0$) and including at least a component among a capacitor (24) and a coil (26);
   - an electromechanical relay contact (14) connected to the resonant circuit (12), the relay contact (14) being movable between a closed state and an open state; and
   - a state determination device (20) for determining the state of the electromechanical relay contact (14) among the closed state and the open state,

   the state determination device (20) comprising:

   - a generation unit (30) for generating an alternative voltage signal and for injecting the generated alternative voltage signal into the resonant circuit (12), the generated alternative voltage signal having a generated frequency ($F_G$) which is comprised between 0.9 times the resonance frequency ($F_0$) and 1.1 times the resonance frequency ($F_0$),
   - a measuring unit (32) for measuring an electric magnitude relative to the impedance (Z) of the resonant circuit (12) after injection of the generated alternative voltage signal, and
   - a determination unit (34) for determining the state of the electromechanical relay contact (14) among the closed state and the open state, according to the measured electric magnitude. **characterized in that** the generation unit (30) includes a generator (38) for delivering several alternative voltage signals with distinct frequencies ($F_1$, $F_2$, $F_3$).

2. The system (10) according to claim 1, wherein the generation unit (30) includes a multiplexer (40) for selecting one signal among the delivered signals, the selected signal being the generated alternative voltage signal.

3. The system (10) according to any one of the preceding claims, wherein the generation unit (30) has an output impedance ($Z_{Out}$) greater than 150 kΩ, preferably comprised between 180 kΩ and 200 kΩ.

4. The system (10) according to any one of the preceding claims, wherein the measuring unit (32) includes at least one filter (42A, 42B, 42C) for attenuating the harmonics of the generated frequency ($F_G$) in the measured electric magnitude.

5. The system (10) according to claim 4, wherein the measuring unit (32) includes several filters (42A, 42B, 42C), one for each frequency ($F_1$, $F_2$, $F_3$) generated by the generator (38).

6. The system (10) according to any one of the preceding claims, wherein the determination unit (34) includes a pulse-width modulator (48) for creating a PWM signal according to the measured electric magnitude, and wherein the state of the electromechanical relay contact (14) is determined according to the created PWM signal.

7. The system (10) according to claim 6, wherein the created PWM signal has a duty cycle value, the duty cycle value being greater for the closed state than for the open state.

8. The system (10) according to any one of claims 1 to 5, wherein the determination unit (34) includes a comparator for comparing the measured electric magnitude with a predetermined threshold.

9. The system (10) according to any one of the preceding claims, wherein the electric magnitude is a voltage.

10. The system (10) according to any one of the preceding claims, wherein the generation unit (30) and the measuring unit (32) are both connected at a connection point (22) between the resonant circuit (12) and the relay contact (14).

11. A method for determining a state of an electromechanical relay contact (14) among a closed state and an open state, the relay contact (14) being movable between the closed state and the open state, the relay contact (14) being connected to a resonant circuit (12), the resonant circuit (12) having a resonance frequency ($F_0$) and including at least a component among a capacitor (24) and a coil (26),
the method including the following steps:

   - generating (100) an alternative voltage signal and injecting (110) the generated alternative voltage signal into the resonant circuit (12), the generated alternative voltage signal having a generated frequency ($F_G$) which is comprised between 0.9 times the resonance frequency ($F_0$) and 1.1 times the resonance frequency ($F_0$),
   - measuring (120) an electric magnitude relative to the impedance (Z) of the resonant circuit (12) after injection (110) of the generated alternative voltage signal, and
   - determining (130) the state of the electromechanical relay contact (14) among the closed state and the open state, according to the measured electric magnitude, **characterized in that**, during the generating step, several alternative voltage signals with distinct frequencies ($F_1$, $F_2$, $F_3$) are delivered into the resonant circuit (12).

**Patentansprüche**

1. Ein System (10), aufweisend:

   - einen Schwingschaltkreis (12), wobei der Schwingschaltkreis (12) eine Resonanzfrequenz ($F_0$) hat und zumindest eine Komponente von einem Kondensator (24) und einer Spule (26) aufweist,
   - einen elektromechanischen Relaiskontakt (14), welcher mit dem Schwingschaltkreis (12) verbunden ist, wobei der Relaiskontakt (14) zwischen einem Geschlossen-Zustand und einem Offen-Zustand bewegbar ist, und
   - eine Zustandsermittlungsvorrichtung (20) zum Ermitteln unter dem Geschlossen-Zustand und dem Offen-Zustand des Zustands des elektromechanischen Relaiskontakts (14),

   wobei die Zustandsermittlungsvorrichtung (20) aufweist:

   - eine Erzeugungseinheit (30) zum Erzeugen eines alternativen Spannungssignals und zum Eingeben des erzeugten alternativen Spannungssignals in den Schwingschaltkreis (12), wobei das erzeugte alternative Spannungssignal eine Erzeugungsfrequenz ($F_G$) hat, welche zwischen dem 0,9-fachen der Resonanzfrequenz ($F_0$) und dem 1,1-fachen der Resonanzfrequenz ($F_0$) liegt,
   - eine Messeinheit (32) zum Messen einer elektrischen Größe relativ zur Impedanz (Z) des Schwingschaltkreis (12) nach dem Eingeben des erzeugten alternativen Spannungssignals, und
   - eine Ermittlungseinheit (34) zum Ermitteln unter dem Geschlossen-Zustand und dem Offen-Zustand des Zustands des elektromechanischen Relaiskontakts (14) gemäß der gemessenen elektrischen Größe,

   **dadurch gekennzeichnet, dass**
   die Erzeugungseinheit (30) einen Erzeuger (38) zum Zuführen mehrerer alternativer Spannungssignale mit ausge-

prägten Frequenzen (F$_1$, F$_2$, F$_3$) aufweist.

2. Das System (10) gemäß Anspruch 1, wobei die Erzeugungseinheit (30) einen Multiplexer (40) zum Auswählen eines Signals unter den zugeführten Signalen aufweist, wobei das ausgewählte Signal das erzeugte alternative Spannungssignal ist.

3. Das System (10) gemäß irgendeinem der vorhergehenden Ansprüche, wobei die Erzeugungseinheit (30) eine Ausgangsimpedanz (Z$_{Out}$) von größer als 150 kΩ hat, bevorzugt zwischen 180 kΩ und 200 kΩ.

4. Das System (10) gemäß irgendeinem der vorhergehenden Ansprüche, wobei die Messeinheit (32) zumindest ein Filter (42A, 42B, 42C) zum Dämpfen der Harmonischen der erzeugten Frequenz (F$_G$) in der gemessenen elektrischen Größe aufweist.

5. Das System (10) gemäß Anspruch 4, wobei die Messeinheit (32) mehrere Filter (42A, 42B, 42C) aufweist, eines für jede Frequenz (F$_1$, F$_2$, F$_3$), welche durch den Erzeuger (38) erzeugt wird.

6. Das System (10) gemäß irgendeinem der vorhergehenden Ansprüche, wobei die Ermittlungseinheit (34) einen Pulsweitenmodulator (48) zum Erzeugen eines PWM-Signals gemäß der gemessenen elektrischen Größe aufweist und wobei der Zustand des elektromechanischen Relaiskontakts (14) gemäße dem erzeugten PWM-Signal ermittelt wird.

7. Das System (10) gemäß Anspruch 6, wobei das erzeugte PWM-Signal einen Tastverhältniswert hat, wobei der Tastverhältniswert für den Geschlossen-Zustand größer ist als für den Offen-Zustand.

8. Das System (10) gemäß irgendeinem der Ansprüche 1 bis 5, wobei die Ermittlungseinheit (34) einen Komparator zum Vergleichen der gemessenen elektrischen Größe mit einem vorbestimmten Schwellenwert aufweist.

9. Das System (10) gemäß irgendeinem der vorhergehenden Ansprüche, wobei die elektrische Größe eine Spannung ist.

10. Das System (10) gemäß irgendeinem der vorhergehenden Ansprüche, wobei die Erzeugungseinheit (30) und die Messeinheit (32) beide mit einem Verbindungspunkt (22) zwischen dem Schwingschaltkreis (12) und dem Relaiskontakt (14) verbunden sind.

11. Ein Verfahren zum Ermitteln eines Zustands eines elektromechanischen Relaiskontakts (14) unter einem Geschlossen-Zustand und einem Offen-Zustand, wobei der Relaiskontakt (14) zwischen dem Geschlossen-Zustand und dem Offen-Zustand bewegbar ist, wobei der Relaiskontakt (14) mit einem Schwingschaltkreis (12) verbunden ist, wobei der Schwingschaltkreis (12) eine Resonanzfrequenz (F$_0$) hat und zumindest eine Komponente von einem Kondensator (24) und einer Spule (26) aufweist,
wobei das Verfahren folgende Schritte aufweist:

- Erzeugen (100) eines alternativen Spannungssignals und Eingeben (110) des erzeugten alternativen Spannungssignals in den Schwingschaltkreis (12), wobei das erzeugte alternative Spannungssignal eine Erzeugungsfrequenz (F$_G$) hat, welche zwischen dem 0,9-fachen der Resonanzfrequenz (F$_0$) und dem 1,1-fachen der Resonanzfrequenz (F$_0$) liegt,
- Messen (120) einer elektrischen Größe relativ zur Impedanz (Z) des Schwingschaltkreis (12) nach dem Eingeben (110) des erzeugten alternativen Spannungssignals, und
- Ermitteln (130) des Zustands des elektromechanischen Relaiskontakts (14) unter dem Geschlossen-Zustand und dem Offen-Zustand gemäß der gemessenen elektrischen Größe,

**dadurch gekennzeichnet, dass**
während des Erzeugungsschritts mehrere alternative Spannungssignale mit ausgeprägten Frequenzen (F$_1$, F$_2$, F$_3$) in den Schwingschaltkreis (12) zugeführt werden.

**Revendications**

1. Système (10) comprenant :

- un circuit résonnant (12), le circuit résonnant (12) ayant une fréquence de résonance ($F_0$) et comprenant au moins un composant parmi un condensateur (24) et une bobine (26) ;
- un contact à relais électromécanique (14) relié au circuit résonnant (12), le contact à relais (14) étant mobile entre un état fermé et un état ouvert ; et
- un dispositif de détermination d'état (20) destiné à déterminer l'état du contact à relais électromécanique (14) parmi l'état fermé et l'état ouvert,

le dispositif de détermination d'état (20) comprenant :

- une unité de génération (30) destinée à générer un signal de tension alternative et à injecter le signal de tension alternative généré dans le circuit résonnant (12), le signal de tension alternative généré ayant une fréquence générée ($F_G$) qui est comprise entre 0,9 fois la fréquence de résonance ($F_0$) et 1,1 fois la fréquence de résonance ($F_0$),
- une unité de mesure (32) destinée à mesurer une magnitude électrique par rapport à l'impédance (Z) du circuit résonnant (12) après l'injection du signal de tension alternative généré, et
- une unité de détermination (34) destinée à déterminer l'état du contact à relais électromécanique (14) parmi l'état fermé et l'état ouvert, selon la magnitude électrique mesurée,

**caractérisé en ce que**
l'unité de génération (30) comprend un générateur (38) destiné à délivrer plusieurs signaux de tension alternative à fréquences distinctes ($F_1$, $F_2$, $F_3$).

2. Système (10) selon la revendication 1, dans lequel l'unité de génération (30) comprend un multiplexeur (40) destiné à sélectionner un signal parmi les signaux délivrés, le signal sélectionné étant le signal de tension alternative généré.

3. Système (10) selon l'une quelconque des revendications précédentes, dans lequel l'unité de génération (30) possède une impédance de sortie ($Z_{Out}$) supérieure à 150 kΩ, de préférence comprise entre 180 kΩ et 200 kΩ.

4. Système (10) selon l'une quelconque des revendications précédentes, dans lequel l'unité de mesure (32) comprend au moins un filtre (42A, 42B, 42C) destiné à atténuer les harmoniques de la fréquence générée ($F_G$) au sein de la magnitude électrique mesurée.

5. Système (10) selon la revendication 4, dans lequel l'unité de mesure (32) comprend plusieurs filtres (42A, 42B, 42C), un pour chaque fréquence ($F_1$, $F_2$, $F_3$) générée par le générateur (38).

6. Système (10) selon l'une quelconque des revendications précédentes, dans lequel l'unité de détermination (34) comprend un modulateur de durée d'impulsion (48) destiné à créer un signal de modulation de durée d'impulsion en fonction de la magnitude électrique mesurée, et dans lequel l'état du contact à relais électromécanique (14) est déterminé en fonction du signal de modulation de durée d'impulsion créé.

7. Système (10) selon la revendication 6, dans lequel le signal de modulation de durée d'impulsion créé possède une valeur de cycle de service, la valeur de cycle de service étant plus élevée pour l'état fermé que pour l'état ouvert.

8. Système (10) selon l'une quelconque des revendications 1 à 5, dans lequel l'unité de détermination (34) comprend un comparateur destiné à comparer la magnitude électrique mesurée avec un seuil prédéterminé.

9. Système (10) selon l'une quelconque des revendications précédentes, dans lequel la magnitude électrique est une tension.

10. Système (10) selon l'une quelconque des revendications précédentes, dans lequel l'unité de génération (30) et l'unité de mesure (32) sont toutes les deux reliées au niveau d'un point de connexion (22) entre le circuit résonnant (12) et le contact à relais (14).

11. Procédé de détermination d'un état d'un contact à relais électromécanique (14) parmi un état fermé et un état ouvert, le contact à relais (14) étant mobile entre l'état fermé et l'état ouvert, le contact à relais (14) étant relié à un circuit résonnant (12), le circuit résonnant (12) ayant une fréquence de résonance ($F_0$) et comprenant au moins un composant parmi un condensateur (24) et une bobine (26),
le procédé comprenant les étapes suivantes :

- la génération (100) d'un signal de tension alternative et l'injection (110) du signal de tension alternative généré dans le circuit résonnant (12), le signal de tension alternative généré ayant une fréquence générée ($F_G$) qui est comprise entre 0,9 fois la fréquence de résonance ($F_0$) et 1,1 fois la fréquence de résonance ($F_0$),
- la mesure (120) d'une magnitude électrique par rapport à l'impédance (Z) du circuit résonnant (12) après l'injection (110) du signal de tension alternative généré, et
- la détermination (130) de l'état du contact à relais électromécanique (14) parmi l'état fermé et l'état ouvert, selon la magnitude électrique mesurée,

**caractérisé en ce que**
pendant l'étape de génération, plusieurs signaux de tension alternative à fréquences distinctes ($F_1$, $F_2$, $F_3$) sont délivrés au circuit résonnant (12).

FIG.1

FIG.2

## FIG.3

## FIG.4

EP 2 960 922 B1

FIG.5

FIG.6

14

| Generating an AC voltage with $F_C$ around $F_0$ | 100 |

| Injecting the generated AC voltage into the resonant circuit | 110 |

| Measuring an electric magnitude relative to Z | 120 |

| Determining the state of the relay contact according to the measured electric magnitude | 130 |

FIG.7

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2104010 B1

- DE 4221916 A1